**Europäisches Patentamt**

**European Patent Office**

**Office européen des brevets**

(11) Numéro de publication: **0 246 139**
**B1**

## (12) FASCICULE DE BREVET EUROPEEN

(45) Date de publication du fascicule du brevet:
**19.12.90**

(21) Numéro de dépôt: **87401007.7**

(22) Date de dépôt: **30.04.87**

(51) Int. Cl.⁵: **H01L 27/02, H01L 27/08**

(54) Dispositif de protection d'entrée pour circuits intégrés en technologie CMOS.

(30) Priorité: **16.05.86 FR 8607082**

(43) Date de publication de la demande:
**19.11.87 Bulletin 87/47**

(45) Mention de la délivrance du brevet:
**19.12.90 Bulletin 90/51**

(84) Etats contractants désignés:
**DE ES FR GB IT NL**

(56) Documents cités:
**PATENT ABSTRACTS OF JAPAN,
vol. 10, no. 121 (E-401)[2178], 7 mai 1986; &
JP-A-60 254 651
PATENT ABSTRACTS OF JAPAN,
vol. 9, no. 102 (E-312)[1825], 4 mai 1985; &
JP-A-59 229 856
PATENT ABSTRACTS OF JAPAN,
vol. 6, no. 155 (E-125)[1033], 17 août 1982; &
JP-A-57 78 164**

(73) Titulaire: **SGS-THOMSON MICROELECTRONICS S.A., 7,
Avenue Galléni, F-94250 Gentiliy(FR)**

(72) Inventeur: **Gaultier, Jean-Marie, THOMSON-CSF
SCPI 19, avenue de Messine, F-75008 Paris(FR)**

(74) Mandataire: **Ballot, Paul Denis Jacques et al, Cabinet
Ballot-Schmit 7, rue le Sueur, F-75116 Paris(FR)**

**Description**

La présente invention concerne un dispositif de protection d'entrée pour circuits intégrés en technologie CMOS, plus particulièrement un dispositif susceptible d'assurer la protection des circuits intégrés CMOS contre les décharges électrostatiques.

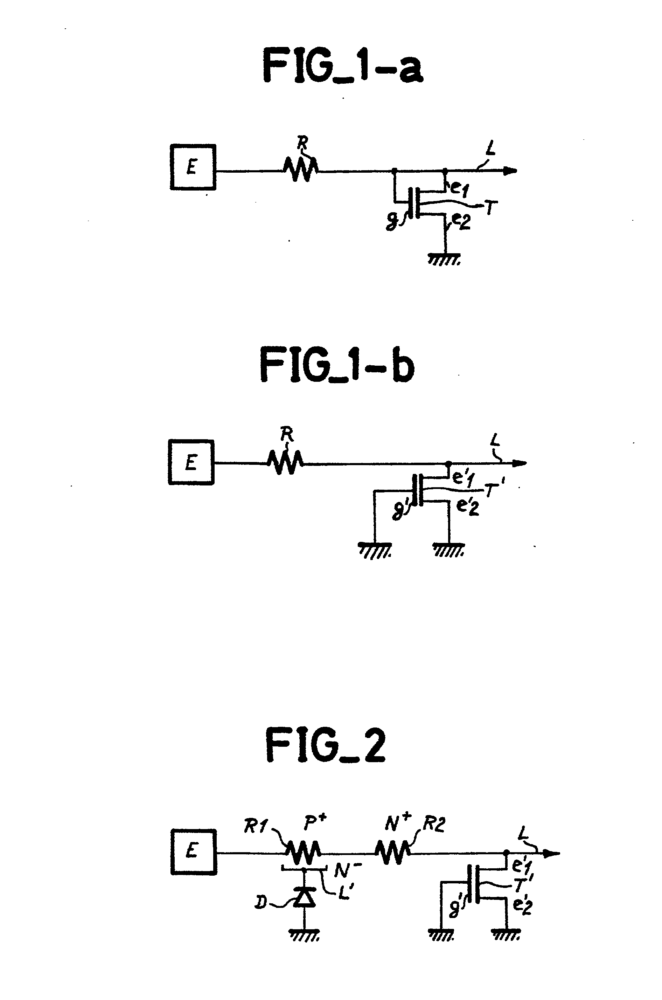

La protection des entrées des circuits intégrés CMOS contre les décharges électrostatiques doit être assurée conformément à la norme américaine MIL STD 883C Méthode 3015.2 qui définit la procédure de test des circuits intégrés ainsi que les valeurs auxquelles ces circuits doivent être testés. D'après cette norme, les circuits intégrés doivent pouvoir supporter une tension transitoire de 2000 volts. Aussi, divers circuits de protection d'entrée ont déjà été proposés pour répondre à cette contrainte. Pourtant, la plupart de ces circuits n'arrivent pas à tenir cette tension. Parmi les circuits de protection d'entrée connus, on peut mentionner notamment ceux représentés sur les figures 1A et 1B.

Le circuit de la figure 1A est constitué par une résistance R montée en série sur la ligne d'entrée L et reliée à un transistor MOS T dont la grille g est connectée sur la ligne L et dont l'électrode e1 ou drain, dans le mode de réalisation représenté, est connectée sur la ligne R tandis que l'électrode e2 ou source est connectée à la masse, l'ensemble résistance et transistor étant monté entre chaque plot d'entrée et chaque entrée du circuit intégré. Dans ce montage, l'isolant de grille du transistor est choisi relativement épais. Le transistor MOS est un transistor communément appelé transistor MOS à oxyde épais.

Selon l'autre mode de réalisation représenté sur la figure 1B, la résistance série R est connectée à un transistor T' constitué par un transistor MOS dont la grille g' est connectée à la masse tandis que les électrodes e'1 et e'2 sont respectivement connectées sur la ligne L et à la masse. Dans ce montage, l'isolant de grille est choisi relativement mince. Il s'agit donc d'un transistor MOS de type normal.

Il est aussi possible d'envisager un circuit de protection d'entrée combinant les deux modes de réalisation ci-dessus. Toutefois, il se pose en général un problème d'encombrement car le transistor MOS doit présenter déjà une largeur d'environ 200 µm pour répondre aux spécifications de la norme. Il existe d'autres types de circuits de protection d'entrée. Toutefois, la plupart ne fonctionnent pas dans tous les cas et peuvent claquer pour une tension de 400 volts, la tension de claquage dépendant en général de l'environnement, par exemple de la proximité des lignes d'alimentation.

Dans les modes de réalisation des figures 1A et 1B, la résistance série R peut être réalisée soit en silicium polycristallin, soit, par exemple, par une diffusion de type N+ dans le cas d'un substrat P. Or, il semble que les problèmes de claquage soient dus principalement à la réalisation de la résistance série. En effet, lorsque la résistance série est réalisée en silicium polycristallin, on observe un problème de tenue en courant qui entraîne un claquage du silicium polycristllin. Si la résistance série est réalisée par une diffusion, on observe, lors de l'application d'une tension élevée, une migration du métal constituant le contact, en général de l'aluminium, dans la diffusion formant la résistance série, cette migration entraînant le perçage de la jonction réalisée entre la résistance série et le substrat.

La présente invention a pour but de remédier aux inconvénients ci-dessus en fournissant un nouveau circuit de protection d'entrée, plus particulièrement une nouvelle résistance série, qui permette de répondre à la norme américaine MIL STD 883C et qui tienne une tension de 2000 volts.

Il est connu un circuit de protection d'entrée comportant entre l'entrée et le circuit proprement dit, une résistance constituée par une diffusion réalisée dans un caisson d'isolement à potentiel flottant, en série avec une seconde résistance. Un tel circuit est par exemple décrit dans le document EP-A 0 177 692

La présente invention a donc pour objet un circuit de protection d'entrée pour circuits intégrés en technologie CMOS du type comportant, entre chaque plot d'entrée et chaque circuit proprement dit, une résistance série et un transistor MOS, la résistance série étant constituée par une diffusion d'un premier type de conductivité réalisée dans un caisson isolé à potentiel flottant faiblement dopé et d'un second type de conductivité réalisée dans un substrat du premier type de conductivité, caractérisé en ce que ledit caisson d'isolation présente une épaisseur de 5 à 10 fois supérieure à l'épaisseur de ladite diffusion.

Selon un mode de réalisation particulier, dans le cas d'un substrat de type P, la résistance est constituée par une diffusion P+ dans un caisson N− flottant.

D'autre part, pour éviter les problèmes de perçage, la diffusion P+ présente, suivant les technologies, une profondeur comprise entre 0,5 µm et 0,7µm, de préférence de l'ordre de 0,6 µm et le caisson N− présente une profondeur comprise entre 3 et 6 microns. De ce fait, en cas de migration du métal constituant le contact, si celui-ci peut traverser la diffusion P+, il est tout à fait improbable que cette migration arrive au niveau de la jonction caisson flottant-substrat. Or, cette jonction ne doit pas être percée sous peine de court-circuit de la jonction diffusion-substrat.

Selon une autre caractéristique de la présente invention, le circuit de protection d'entrée comporte de plus une seconde résistance montée en série entre la première résistance série et le transistor. Cette seconce résistance est constituée par une diffusion de type N+ dans le cas d'un substrat P.

En ce qui concerne le transistor, il peut être réalisé conformément à l'art antérieur, soit par un transistor MOS à oxyde épais dont la grille est connectée sur la ligne d'entrée, soit par un transistor MOS classique à oxyde mince avec sa grille connectée à la masse.

D'autres caractéristiques et avantages de la présente invention apparaîtront à la lecture de la description d'un mode de réalisation préférentiel d'un circuit de protection d'entrée conforme à la présente invention faite avec référence aux dessins ci-annexés dans lesquels :

- les figures 1A et 1B, déjà décrites, représentent

des circuits de protection d'entrée conformes à l'art antérieur,

- la figure 2 représente un schéma électrique d'un circuit de protection d'entrée conforme à la présente invention,

- les figures 3A et 3B sont une vue de dessus et une vue en coupe du circuit de la figure 2 réalisé en technologie CMOS.

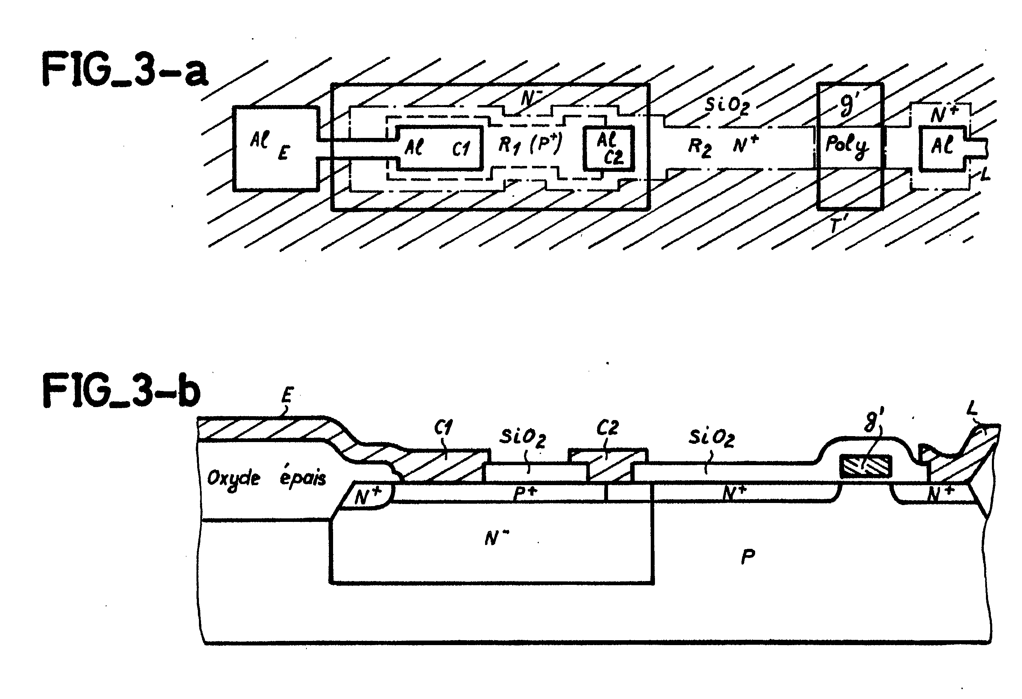

Comme représenté sur les figures 2 et 3, le circuit de protection d'entrée conforme à la présente invention comporte essentiellement, entre chaque plot d'entrée E et chaque ligne d'entrée L des circuits intégrés réalisés en technologie CMOS, une résistance R1 réalisée par une diffusion dans un caisson d'isolement à potentiel flottant symbolisé par la diode D et la ligne L'. Cette résistance série R1 est connectée à une seconde résistance R2 réalisée par une diffusion de type opposé, cette résistance R2 étant elle-même connectée à un transistor T' qui, dans le mode de réalisation représenté, est identique au transistor T' de la figure 1B. De manière plus détaillée et comme représenté sur les figures 3A et 3B, dans le cas d'un substrat P, la résistance R1 est constituée par une diffusion P+ qui est réalisée dans un caisson d'isolement flottant réalisé par une diffusion N−. Comme représenté sur les figures, la diffusion P+ est entourée, pour des raisons technologiques, par des diffusions N+. Pour former la résistance R2, l'une de ces diffusions N+ se prolonge hors du caisson N− jusqu'au transistor T' dont les deux électrodes sont formées par des diffusions N+ et la grille g' par un dépôt de silicium polycristallin. Sur la figure 3A, des hachures obliques définissent les zones d'oxyde épais entourant les régions actives (transistors, résistances, etc.) du circuit. D'autre part, comme représenté sur les figures 3A et 3B, des contacts C1 et C2 ont été réalisés, de manière connue par ouverture de la couche de SiO₂, au-dessus de la diffusion P+ et au niveau de la diffusion P+ et de la diffusion N+ constituant la résistance R2. Ces contacts ont été réalisés par dépôt d'aluminium. Le contact C1 est d'autre part relié au plot d'entrée E constitué par un dépôt d'aluminium sur l'oxyde épais.

Selon une autre caractéristique de la présente invention et pour améliorer la dissipation thermique, le contact C1 est un contact présentant une surface relativement importante.

D'autre part, pour permettre un fonctionnement efficace du circuit d'entrée conforme à la présente invention, la diffusion P+ présente de manière classique une épaisseur comprise entre 0,5 µm et 0,7 µm, de préférence de l'ordre de 0,6 µm tandis que le caisson d'isolement N− présente une épaisseur comprise entre 3 et 6 µm. Comme expliqué ci-dessus, l'épaisseur du caisson d'isolement évite, en cas de migration de l'aluminium formant le contact C1, que cette migration n'atteigne la jonction N-P et ne la détruise.

En fait, la jonction entre le caisson N− et le substrat est très fortement capacitive. En conséquence, l'ensemble constitué par la diffusion P+ et le caisson N− joue le rôle d'un circuit RC à constantes réparties. Aussi, lorsque l'on envoie pour les tests un pic calibré à 2000 volts, on obtient en sortie de R1 un pic fortement amorti, ce qui permet au transistor T' de fonctionner normalement.

On a décrit ci-dessus un mode de réalisation de la présente invention, toutefois il est évident pour l'homme de l'art que le transistor T' peut être remplacé par le transistor T représenté à la figure 1A sans sortir du cadre de la présente invention. D'autre part, selon une caractéristique de la présente invention, la résistance R2 est facultative et la résistance R1 peut être connectée directement au transistor de protection.

## Revendications

1. Un circuit de protection d'entrée pour circuit intégré en technologie CMOS du type comportant, entre chaque plot d'entrée et chaque circuit proprement dit, une résistance série (R1) et un transistor MOS (T'), la résistance série étant constituée par une diffusion d'un premier type de conductivité réalisée dans un caisson d'isolement à potentiel flottant faiblement dopé et d'un second type de conductivité réalisé dans un substrat du premier type de conductivité, caractérisé en ce que ledit caisson d'isolement présente une épaisseur de 5 à 10 fois supérieure à l'épaisseur de la dite diffusion.

2. Un circuit de protection selon la revendication 1, caractérisé en ce que, dans le cas d'un substrat de type P, la résistance (R1) est constituée par une diffusion de type P+ dans un caisson d'isolement N− à potentiel flottant.

3. Un circuit de protection selon l'une quelconque des revendications 1 et 2, caractérisé en ce qu'il comporte de plus une seconde résistance (R2) montée en série entre la première résistance série (R1) et le transistor (T').

4. Un circuit de protection selon l'une quelconque des revendications 2 et 3, caractérisé en ce que la seconde résistance (R2) est constituée par une diffusion de type N+.

## Patentansprüche

1. Eingangsschutzschaltung für integrierte Schaltung in CMOS-Technologie, mit einem zwischen jedem Eingangsanschluß und jeder Schaltung im engeren Sinn angeordneten Reihenwiderstand (R1) und einem MOS-Transistor (T'), wobei der Reihenwiderstand durch eine Diffusion eines ersten Leitungstyps, die in einem auf einem schwebenden Potential liegenden und schwach dotierten Isolationsfeld verwirklicht ist, und eines zweiten Leitungstyps, die in einem Substrat vom ersten Leitungstyp verwirklicht ist, gebildet wird, dadurch gekennzeichnet, daß das Isolierfeld eine Dicke aufweist, die fünf bis zehn mal größer als die Dicke der Diffusion ist.

2. Schutzschaltung gemäß Anspruch 1, dadurch gekennzeichnet, daß bei einem Substrat vom P-Typ der Widerstand (R1) durch die Diffusion vom P+-Typ gebildet wird, die in einem auf schwebendem Potential liegenden Isolierfeld vom N−-Typ verwirklicht ist.

3. Schutzschaltung gemäß einem der Ansprüche 1 und 2, dadurch gekennzeichnet, daß sie außerdem einen zweiten Widerstand (R2) umfaßt, der mit dem ersten Reihenwiderstand (R1) und mit dem Transistor (T') in Reihe geschaltet ist.

4. Schutzschaltung gemäß einem der Ansprüche 2 und 3, dadurch gekennzeichnet, daß der zweite widerstand (R2) durch eine Diffusion vom N+-Typ gebildet wird.

**Claims**

1. An input protection circuit for a CMOS technology integrated circuit of the type comprising, between each input contact stud and each circuit properly so called, a series resistor (R1) and an MOS transistor (T'), the series resistor being made by diffusion of a first type of conductivity produced in an insulating weakly doped island at a floating potential and of a second type of conductivity in a substrate of the first type of conductivity, characterized in that the said insulating island has a thickness 5 to 10 times greater than the thickness of the said diffusion.

2. The protection circuit as claimed in claim 1, characterized in that in the case of the substrate being of the P type, the resistor is produced by type P+ diffusion in an floating potential N− insulating island.

3. The protection circuit as claimed in claim 1 or claim 2, characterized in that it furthermore comprises a second resistor (R2) connected in series between the first series resistor (R1) and the transistor (T').

4. The protection circuit as claimed in claim 2 or claim 3, characterized in that the second resistor (R2) is produced by N+ type diffusion.

## FIG_1-a

## FIG_1-b

## FIG_2

## FIG_3-a

## FIG_3-b

EP 0 246 139 B1